# EUROPÄISCHE PATENTSCHRIFT

(11) **EP 0 826 241 B1**
(45) Veröffentlichungstag und Bekanntmachung des Hinweises auf die Patenterteilung: **26.03.2003**
(21) Anmeldenummer: 96919546.0
(22) Anmeldetag: 15.05.1996
(51) Int. Cl.: H01L 27/02

(54) **SCHALTUNGSANORDNUNG ZUR VERRINGERUNG EINER MINORITÄTSTRÄGERINJEKTION IN EIN SUBSTRAT**
CIRCUIT FOR REDUCING THE INJECTION OF A MINORITY CARRIER INTO A SUBSTRATE
CIRCUITERIE PERMETTANT DE REDUIRE UNE INJECTION DE PORTEUR MINORITAIRE DANS UN SUBSTRAT

(30) Priorität: 19.05.1995 DE 19518524
(43) Veröffentlichungstag der Anmeldung: 04.03.1998
(73) Patentinhaber: Infineon Technologies AG, 81669 München (DE)
(72) Erfinder: DRAXELMAYR, Dieter, A-9500 Villach (AT)
(74) Vertreter: Müller - Hoffmann & Partner
(86) Internationale Anmeldenummer: DE9600859
(87) Internationale Veröffentlichungsnummer: WO96036997

(56) Entgegenhaltungen:
- EP-A- 0 409 158

## Beschreibung

Die Erfindung betrifft eine Schaltungsanordnung zur Verringerung einer Minoritätsträgerinjektion in ein Substrat, das Gebiete enthält, die einen pn-Übergang bilden, wobei ein Transistor vorgesehen ist, der mit einem externen Anschluß der Schaltungsanordnung verbunden ist.

Integrierte Halbleiterschaltungen enthalten ein Substrat, in das jeweils p- und n-dotierte Gebiete in vorgegebener Struktur eingebettet sind. Z. B. können auf einem p-Substrat n-dotierte Wannen angeordnet sein, die die elektrischen Bauelemente aufnehmen. Der pn-Übergang zum Substrat muß immer in Sperrichtung vorgepolt sein, damit keine Minoritätsträger in das Substrat injiziert werden. Derartige Minoritätsträger breiten sich durch Diffusion aus und können, wenn sie andere Schaltungselemente erreichen, aufgrund ihrer parasitären Eigenschaften eine Fehlfunktion verursachen. Typischerweise wird deshalb das Substrat mit dem niedrigsten Potential der Schaltung verbunden. Andererseits ist bekannt, daß durch eine äußere Beschaltung der integrierten Schaltung Störungen an die Schaltung herangetragen werden. Besonders kritische Punkte sind deshalb die externen Anschlüsse der Schaltung, insbesondere die Ein- und Ausgänge der Schaltung.

Lasten mit induktivem Anteil können bei einer plötzlichen Unterbrechung des durch sie fließenden Stroms eine Gegerispannung erzeugen. Darüber hinaus sind andere Störungen, beispielsweise durch Änderungen der Versorgungsspannung möglich. Die Effekte haben zur Folge, daß ein Minoritätsträgerstrom in das Substrat injiziert wird, der in der Größenordnung des Nutzstroms durch einen Transistor liegen kann. Die Rückseite des Chips und die Wannen über dem Substrat wirken als Senke für die Ladungsträger. Die Bewegung der Minoritätsträger aufgrund des Konzentrationsgefälles bewirkt sogenannte Querströme. Nur ein Teil der Minoritätsträger kombiniert im Substrat, da die Kristallqualität des Substrats im allgemeinen so gut ist, daß nur geringe Rekombinationsgeschwindigkeiten bzw. daß hohe Trägerlebensdauern auftreten. Die Bauelement-Wannen der Schaltung müssen deshalb große Querströme aufnehmen, die zu einer ungewollten Aktivierung von bipolaren Parasitärtransistoren und damit zu Fehlfunktionen führt.

Aus der EP 0 284 979 ist eine integrierte Schaltungsanordnung bekannt, die einen mit einem externen Anschluß verbundene Schalttransistor zum Schalten einer massebezogenen, induktiven Last aufweist. Zum Vermeiden von unerwünschten Substratströmen ist das Substrat über je eine Diode mit dem externen Anschluß bzw. dem Bezugspotential zum Anschluß an ein Referenzpotential verbunden.

Weiterhin ist aus der DE 44 11 869.4 bekannt, ein hochdotiertes Substrat mit einer darüberliegenden niedrigdotierten Schicht gleicher Leitfähigkeit zu verwenden und die Wannen mit einem Schutzring zu umgeben. Diese Maßnahme verhindert zwar nicht die Injektion von Minoritätsträgern, schränkt aber die Verbreitung der Ladungsträger stark ein. Außerdem ist eine derartige Maßnahme in typischen Bipolartechnologien nur stark eingeschrankt wirksam, da keine Substrate mit epitaktischen Schichten wie in MOS-Technologien verwendet werden.

Aus der EP-A-0 409 158 ist eine Schaltungsanordnung zur Verringerung einer Minoritätsträgerinjektion in ein Substrat bekannt, bei der eine Regelschleife, bestehend aus einem Komparator und einem Transistor, zusammen mit einer Nutzschaltung ausgebildet ist.

Der Erfindung liegt deshalb die Aufgabe zugrunde, durch eine verbesserte schaltungstechnische Lösung die Injektion von Minoritätsträgern in ein Substrat zu vermeiden oder zumindest zu verringern.

Diese Aufgabe wird mit einer Schaltungsanordnung mit den Merkmalen von Patentanspruch 1 gelöst. Ausgestaltungen dieser Schaltungsanordnung sind in den Unteransprüchen angegeben.

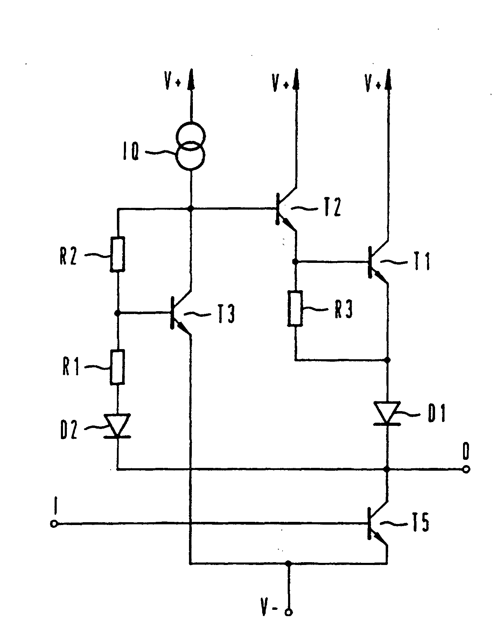

Die Erfindung wird nachfolgend anhand eines in der Figur der Zeichnung dargestellten Ausführungsbeispiels näher erläutert.

Gemäß der Fig ist als Beispiel für die auf bzw. in einem Substrat realisierte Nutzschaltung ein Schalttransistor TS dargestellt, der basisseitig mit einem Eingangsanschluß I und dessen Kollektoranschluß mit einem Ausgangsanschluß O verbunden ist. Der Emitter des Transistors TS liegt auf Bezugspotential V-. TS kann beispielsweise als npn-Tranistor in einer üblichen Bipolartechnologie in bzw. auf einem Substrat hergestellt sein. Die Nutzschaltung kann auch eine kompliziertere und aufwendigere Schaltung sein, so daß TS lediglich das einfachste Beispiel darstellt.

Die Injektion von Minoritatstragern in das Substrat wird insbesondere durch die Reihenschaltung eines ersten Transistors T1, eines zweiten Transistors T2 und einer Diode D1 verhindert, die zwischen ein Versorgungspotential V+ und den Ausgangsanschluß bzw. den externen Anschluß O der Schaltung angeordnet ist. Dabei ist T2 emitterseitig mit der Basis von T1 und der Emitter von T1 über die Diode D1 mit dem externen Anschluß verbunden. D1 ist kathodenseitig an O angeschlossen. Der Emitter von T2 ist zusätzlich über den Widerstand R3 mit dem Emitter von T1 verbunden. Die Kollektoren von T1 und T2 liegen an dem positiven Versorgungspotential V+. Bei einer derartigen Schaltung ist ein Schutz gegen Minoritätsträger bereits dann gegeben, wenn die Basis von T1 oder T2 mit einem Referenzpotential verbunden ist. Diese Ausführungsform ist in der Fig nicht ausdrücklich dargestellt.

Die Elemente T1 und D1 sind für die Funktion der Minoritätsträgerunterdrückung notwendig. Wenn eine derartige Störung beispielsweise über den externen Anschluß O an die Schaltung herangetragen wird, schützt D1 den Emitter von T1 vor dem Durchbruch. T1 ist als Leistungstransistor notwendig, um energiereiche Impulse am Anschluß O abfangen zu können. T2 ist ein Darlingtontransistor, damit bei großem Strom der Kollektor von T3 nicht zu stark belastet wird. Bei kleinen Strömen können T2 und R3 entfallen und die Basis von T1 direkt am Kollektor von T3 angeschlossen werden. T2 versorgt gemäß der Figur die Basis von T1 mit dem nötigen Strom, wenn die Schutzschaltung aktiviert ist. Es kann sein, daß die zuvor beschriebene Schaltungsanordnung in ihrer Wirksamkeit gegen die Injektion von Minoritätsträgern eingeschränkt ist, da die Spannungskonstanz der Reihenschaltung aus den beiden Transistoren T1 und T2 sowie der ersten Diode D1 nicht ausreicht. Aus diesem Grund schlägt die Erfindung als weiteres Ausführungsbeispiel vor, daß eine Regelschleife von dem externen Anschluß auf den Steueranschluß des ersten Transistors vorgesehen ist. Diese Regelschleife ist in der Fig durch die Elemente T3, D2 sowie durch die in Serie geschalteten Widerstände R1 und R2 realisiert. Der Ausgangskreis von T3 ist zwischen den Basisanschluß von T2 und Bezugspotential V- geschaltet. Vom Kollektor von T3 bzw. der Basis von T2 liegt ein Widerstand R2 gegen die Basis von T3. Der gemeinsame Knotenpunkt von T2, T3 und R2 wird über eine Stromquelle IQ an das positive Versorgungspotential V+ angeschlossen. Die Stromquelle IQ kann beispielsweise durch einen Widerstand realisiert sein. Der Verbindungspunkt der Basis von T3 mit dem Widerstand R2 ist über die Serienschaltung aus dem Widerstand R1 und die zweite Diode D2 mit dem externen Anschluß O verbunden. Die zweite Diode D2 liegt dabei kathodenseitig an O.

Nachfolgend wird die Funktion in der Schaltung näher beschrieben. Wenn die Ausgangsspannung am externen Anschluß O aufgrund einer externen Störung unter das Bezugspotential V-, d.h. das Substratpotential zu sinken beginnt, wird der Regeltransistor T3 mit Hilfe der zweiten Diode D2 und des Widerstandes R1 abgeschaltet. Das Kollektorpotential von T3 steigt und bringt die Reihenschaltung aus T1, T2 und der ersten Diode D1 zum Leiten. Damit wird die Spannung am externen Anschluß O angehoben und die Regelschleife geschlossen. Es stellt sich ein Gleichgewichtszustand ein, in dem die Ausgangsspannung am externen Anschluß O geringfügig unterhalb des Bezugspotentials liegt, so daß noch keine Minoritätsträgerinjektion stattfinden kann.

Im inaktiven Zustand, d.h. bei einem ausreichend hohen Potential am externen Anschluß O sperrt die zweite Diode D2. In diesem Fall ist der Regeltransistor T3 durchgeschaltet und sein Kollektorpotential liegt ungefähr eine Diodenschwellspannung über dem Bezugspotential. Damit ist aber auch die Reihenschaltung aus den Elementen T1, T2 und D1 gesperrt, so daß die Schutzschaltung insgesamt inaktiv ist.

Die anhand bipolarer Transistoren beschriebene Schutzschaltung kann selbstverständlich auch in entsprechender Weise mit MOS-Transistoren realisiert werden.

## Patentansprüche

1. Schaltungsanordnung zur Verringerung einer Minoritätsträgerinjektion in ein Substrat, das Gebiete enthält, die einen pn-Übergang bilden, und das einen Transistor (TS) aufweist, der mit einem externen Anschluß (0) der Schaltung verbunden ist, wobei der Transistor (TS) basisseitig mit einem Eingangsanschluß (I) verbunden ist,
wobei eine Reihenschaltung aus einem ersten Transistor (T1) und einer mit dem externen Anschluß verbundenen Diode (D1) vorgesehen ist,
wobei die Reihenschaltung zwischen einem Versorgungspotential (V+) und dem externen Anschluß (0) der Schaltung angeordnet ist
und wobei die Schaltungsanordnung eine Regelschleife (T3, D2, R1, R2) aufweist, die einerseits mit dem externen Anschluß (0) und andererseits mit dem Steueranschluß des ersten Transistors (T1) verbunden ist.

2. Anordnung nach Anspruch 1,
wobei die Regelschleife einen Regeltransistor (T3) enthält, der mit seinem ersten Ausgangsanschluß mit dem Steueranschluß des ersten Transistors (T1) und mit seinem zweiten Ausgangsanschluß mit einem Bezugspotential (V-) verbunden ist und dessen Steueranschluß mit dem externen Anschluß (O) über einen Widerstand (R1) und eine zweite Diode (D2) verbunden ist.

3. Anordnung nach Anspruch 2,
wobei der erste Ausgangsanschluß des Regeltransistors (T3) über einen Widerstand (R2) mit dem Steueranschluß des Regeltransistors (T3) verbunden ist.

4. Anordnung nach einem der Ansprüche 1 bis 3,
wobei dem ersten Transistor (T1) ein zweiter Transistor (T2) vorgeschaltet ist, dessen Steuereingang mit dem Ausgang des Regeltransistors (T3) und dessen Ausgangsanschlüsse mit dem Versorgungspotential (V⁺) bzw. dem Steueranschluß des ersten Transistors (T1) verbunden sind.

5. Anordnung nach Anspruch 4,
wobei der Verbindungspunkt des zweiten Transistors (T2) mit dem Steuereingang des ersten Transistors (T1) über einen Widerstand (R3) mit dem Ausgang des ersten Transistors (T1) verbunden ist.

6. Anordnung nach einem der Ansprüche 1 bis 5,
wobei die jeweilige Kathode der ersten Diode (D1) und der zweiten Diode (D2) mit dem externen Anschluß (O) der Schaltung verbunden ist.

## Claims

1. Circuit arrangement for reducing injection of minority carriers into a substrate containing regions which form a pn junction, and having a transistor (TS) which is connected to an external terminal (0) of the circuit, the transistor (TS) being connected on the base side to an imput terminal (I), a series circuit which consists of a first transistor (T1) and of a diode (D1) converted to the external terminal being provided, the series circuit being arranged between a supply potential (V+) and the external terminal (0) of the circuit,
and the current arrangement having a control loop (T3, D2, R1, R2) which is connected on the one hand to the external terminal (0) and on the other hand to the control terminal of the first transistor (T1).

2. Arrangement according to Claim 1, in which the control loop contains a control transistor (T3) which is connected by its first output terminal to the control terminal of the first transistor (T1) and by its second ouput terminal to a reference potential (V-), and whose control terminal is connected to the external terminal (O) via a resistor (R1) and a second diode (D2).

3. Arrangement according to Claim 2, in which the first output terminal of the control transistor (T3) is connected via a resistor (R2) to the control terminal of the control transistor (T3).

4. Arrangement according to one of Claims 1 to 3, in which the first transistor (T1) has a second transistor (T2) connected in front of it, the control input of which is connected to the output of the control transistor (T3) and the output terminals of which are connected to the supply potentials (V+) or to the control terminal of the first transistor (T1).

5. Arrangement according to Claim 4, in which the point of connection of the second transistor (T2) to the control input of the first transistor (T1) is connected via a resistor (R3) to the output of the first transistor (T1)

6. Arrangement according to one of Claims 1 to 5, in which the respective cathode of the first (D1) and of the second diode (D2) is connected to the external terminal (O) of the circuit.

## Revendications

1. Montage permettant de diminuer une injection de porteurs minoritaires dans un substrat qui comporte des zones qui forment une jonction pn et qui a un transistor (TS) qui est relié à une borne (0) extérieure du montage, le transistor (TS) étant relié du côté de la base à une borne (I) d'entrée,
dans lequel il est prévu un circuit série constitué d'un premier transistor (T1 ) et d'une diode (D1) reliée à la borne extérieure,
dans lequel le circuit série est monté entre un potentiel (V⁺) d'alimentation et la borne (0) extérieure du montage,
et dans lequel le montage comprend une boucle (T3, D2, R1, R2) de régulation qui est reliée, d'une part, à la borne (0) extérieure et, d'autre part, à la home de commande du premier transistor (T1).

2. Montage suivant la revendication 1,
dans lequel la boucle de régulation comporte un transistor (T3) de régulation qui est relié par sa première home de sortie à la home de commande du premier transistor (T1) et par sa deuxième home de sortie à un potentiel (V-) de référence et dont la home de commande est reliée à la home (O) extérieure par une résistance (R1) et une deuxième diode (D2).

3. Montage suivant la revendication 2,
dans lequel la première home de sortie du transistor (T3) de régulation est reliée par une résistance (R2) à la home de commande du transistor (T3) de régulation.

4. Montage suivant l'une des revendications 1 à 3,
dans lequel il est monté en amont du premier transistor (T1) un deuxième transistor (T2) dont l'entrée de commande est reliée à la sortie du transistor (T3) de régulation et dont des homes de sortie sont reliées au potentiel (V+) d'alimentation et à la borne de commande du premier transistor (T1).

5. Montage suivant la revendication 4,
dans lequel le point de liaison du deuxième transistor (T2) avec l'entrée de commande du premier transistor (T1) est relié par une résistance (R3) à la sortie du premier transistor (T1).

6. Montage suivant l'une des revendications 1 à 5,
dans lequel la cathode respective de la première diode (D1) et de la deuxième diode (D2) est reliée à la home (O) extérieure du montage.
